(19) Europäisches Patentamt

European Patent Office

Office européen des brevets

(11) **EP 1 236 052 B1**

(12) **FASCICULE DE BREVET EUROPEEN**

(45) Date de publication et mention
de la délivrance du brevet:
**11.06.2003 Bulletin 2003/24**

(51) Int Cl.7: **G01R 31/305**

(86) Numéro de dépôt international:
**PCT/FR00/03262**

(21) Numéro de dépôt: **00985307.8**

(22) Date de dépôt: **23.11.2000**

(87) Numéro de publication internationale:
**WO 01/038892 (31.05.2001 Gazette 2001/22)**

(54) **TEST ELECTRIQUE DE L'INTERCONNEXION DE CONDUCTEURS ELECTRIQUES SUR UN SUBSTRAT**

ELEKTRISCHE PRÜFUNG DER VERBINDUNG VON LEITERN AUF EINEM SUBSTRAT

ELECTRICAL TEST OF THE INTERCONNECTION OF CONDUCTORS ON A SUBSTRATE

(84) Etats contractants désignés:
**AT BE CH CY DE DK ES FI FR GB GR IE IT LI LU MC NL PT SE TR**

(30) Priorité: **26.11.1999 FR 9914876**

(43) Date de publication de la demande:
**04.09.2002 Bulletin 2002/36**

(73) Titulaire: **Vaucher, Christophe**
**83150 Bandol (FR)**

(72) Inventeur: **Vaucher, Christophe**
**83150 Bandol (FR)**

(74) Mandataire: **Marchand, André et al**
**OMNIPAT,**
**24 Place des Martyrs de la Résistance**
**13100 Aix-en-Provence (FR)**

(56) Documents cités:
**US-A- 4 573 008      US-A- 4 837 506**
**US-A- 4 967 152**

## Description

La présente invention concerne un procédé pour tester électriquement des conducteurs.

Elle s'applique notamment, mais non exclusivement au test électrique de substrats, tels les puces à semi-conducteur ou circuits intégrés, et les circuits imprimés..

Les machines de test actuelles permettent la mesure de la continuité des pistes et leur isolation. A cet effet, elles utilisent des outillages permettant de prélever ou extraire des électrons de conducteurs. Parmi ces outillages, il existe ce que l'on appelle les "planches à clous" qui sont spécifiques à chaque type de circuit. Il s'avère qu'avec la diminution des dimensions des composants électroniques et la densité des pistes de circuits imprimés qui augmente considérablement, ces outillages deviennent de plus en plus complexes à réaliser, et donc très coûteux et moins fiables. En outre, leur délai de fabrication (de un à plusieurs jours) augmente, ce qui va dans un sens opposé à la plus grande flexibilité de fabrication requise par les nouvelles générations de circuits imprimés (le raccourcissement des cycles de production impose une contrainte lourde sur la fabrication de ces planches à clous).

Pour prélever ou extraire des électrons de conducteurs, il existe également des dispositifs qui utilisent une source de lumière cohérente de haute énergie, qui par effet photoélectrique, entraîne la montée de la tension de ces conducteurs. De tels outils sont par exemple décrits dans les brevets US 4,837,506 et 4,967,152.

L'effet photoélectrique consiste en l'émission d'électrons par un métal sous l'action de radiations lumineuses. Plus généralement, l'effet photoélectrique recouvre plusieurs phénomènes d'interaction de la lumière et de la matière, dans lesquels des photons cèdent leur énergie à des électrons. On distingue ainsi l'effet photoélectrique externe, appelé aussi photo-émission, et l'effet photoélectrique interne qui comprend la photoconductivité, l'effet photovoltaïque et la photoionisation.

Il se traduit par l'absorption de certains photons par le métal : si l'énergie d'un photon est supérieure à l'énergie liant un électron à un atome du métal, cet électron peut alors quitter son orbitale atomique, acquérant une énergie cinétique et créant un courant électrique.

Dans l'effet photoélectrique, les électrons sont donc éjectés d'un métal (ou conducteur) par la collision avec des photons incidents. En fait, les électrons sont maintenus à l'intérieur du métal par une barrière de potentiel, appelé "Work Function" (WF). Pour permettre l'éjection d'un électron, l'énergie des photons doit être supérieure à WF. Par exemple, pour le cuivre, WF vaut environ 4,3 eV (électrons-Volts), et en conséquence, la longueur d'onde de la source de lumière cohérente doit être plus courte que $1,24 / 4,3 = 290$ nm. Des longueurs d'onde plus courtes permettent la libération d'électrons avec une énergie cinétique non nulle.

L'effet photoélectrique ne dépend pas de l'intensité de la source lumineuse. Il peut donc être observé même pour de très faibles puissances mises en jeu, ce qui permet d'envisager un fonctionnement qui n'endommage pas le conducteur. Il ne se produit pas au niveau des isolants, bien que des ionisations puissent apparaître sous l'action de photons hautement énergétiques.

Les électrons éjectés peuvent être collectés par une électrode polarisée positivement, et le courant ainsi créé peut être mesuré. Cela nécessite un vide partiel, de telle manière que la plupart des électrons puissent atteindre l'électrode, sans heurter trop de molécules d'air.

La puissance de la source ultraviolette, typiquement un laser, dépend du courant et du temps de chargement des conducteurs. Par exemple, si un conducteur présente une capacité de 100 pF, et si l'on souhaite charger positivement ce conducteur à 100 V en une ms, alors le courant correspondant sera :

$$I = Q \, V / t = 100 \times 10^{-10} / 0,001 = 10^{-5} \, A$$

La puissance nécessaire du laser devra être ;

$$P = I \times Eph / Efficacité = 10^{-5} \times 4,8 / 0,05 \approx 1 \, mW$$

en supposant que 5% des photons émis produisent effectivement l'effet photoélectrique.

Si l'on veut maintenant procéder à la vérification de l'interconnexion de substrats, tels que des puces à semi-conducteur ou des circuits imprimés, il s'agit de vérifier qu'aucun conducteur ne présente de coupure franche ou partielle entre deux plages sensées accueillir des composants, par rapport au modèle théorique, et de vérifier que chaque conducteur n'est pas en court-circuit franc ou partiel avec un ou plusieurs autres conducteurs.

Dans l'art antérieur (brevet US 4,967,152, par exemple), les coupures sont détectées suivant le principe suivant :

Une grille fine métallique est disposée à la verticale du substrat à tester. Elle est portée à un potentiel positif par rapport au substrat à vérifier, par exemple de l'ordre de 100 V.

La source ultraviolette passant de manière quasi transparente au travers de la grille métallique, est dirigée sur l'extrémité d'un conducteur et entraîne la libération d'électrons du conducteur correspondant. Ces électrons sont alors capturés par la grille, qui les attire. Un courant est alors collecté. Cette opération est poursuivie jusqu'à ce que le courant collecté atteigne un seuil déterminé, qui signifie que le conducteur est alors chargé électriquement à la valeur d'environ 100 V. Le temps de charge dépend entre autre de la capacité du conducteur, et de la puissance du laser.

Un conducteur préalablement chargé de cette manière ne conduit pas à la libération d'autres électrons dans les mêmes conditions d'excitation, et quel que soit l'endroit où l'on vient procéder à son excitation. Par contre, s'il est coupé quelque part, et si l'on vient procéder à la même excitation de l'autre côté de la coupure, alors cette partie n'ayant pas été chargée au préalable va faire l'objet d'une émission d'électrons sous la forme d'une charge de capacité.

Ensuite, on réitère la méthode pour tester la continuité des autres conducteurs.

Cependant, dans le vide partiel utilisé, les conducteurs ne se déchargent pas. Donc à la fin du test décrit ci-dessus, le substrat sera entièrement chargé. Dans la mesure ou la source laser n'est pas affectée par la charge des conducteurs voisins, cela ne perturbe pas outre mesure l'effet photoélectrique, mais les électrons éjectés ont tendance à rejoindre les conducteurs voisins préalablement chargés à 100 V, et non plus seulement la grille, ce qui altère de manière significative le courant collecté par la grille, et fausse les conclusions tirées de la valeur des courants mesurés, pouvant conduire à un diagnostic erroné.

Une alternative possible est d'augmenter progressivement la tension de la grille de collecte au fur et à mesure du test, mais on observe néanmoins une perte d'électrons, ces derniers étant collectés par des conducteurs de potentiel voisins (les derniers à avoir été testés). Par ailleurs, le nombre de conducteurs pouvant être de l'ordre de plusieurs milliers, l'idée d'augmenter le potentiel par sauts progressifs au fur et à mesure des conducteurs atteint vite ses limites.

De plus, la mesure de résistance, critère important dans la validation du principe de test d'une technologie, n'est ici pas vraiment possible : même de faibles traces de conducteurs reliant de manière défectueuse les deux portions d'un seul et même conducteur présenteront une constante de temps RC suffisamment courte pour ne pas être détectée, alors que la résistance correspondante (élevée dans ce cas) de la liaison devrait être analysée comme un réel défaut.

Les courts-circuits sont détectés dans l'art antérieur en chargeant un conducteur donné dans un premier temps, et en recherchant d'autres conducteurs ayant un potentiel similaire sur le substrat, mettant en évidence une connexion physique avec le conducteur de référence, et donc l'existence d'un court-circuit. Ici encore se pose le problème de la décharge des conducteurs.

L'utilisation de l'effet photoélectrique pour la mesure de courts-circuits et de coupures sur des substrats possédant un grand nombre de conducteurs pose donc problème.

Dans un art antérieur plus récent, une seule source lumineuse est typiquement utilisée pour effectuer des tests de circuits, ce qui en réduit fortement la productivité et donc en augmente le coût.

Des systèmes de test sans contact ont pu voir le jour dans un passé récent. Toutefois, ces systèmes ne peuvent pas mesurer les faibles résistances d'interconnexion de certains substrats, tels les circuits imprimés entrant dans la composition des nouvelles générations de boîtiers pour puces à semi-conducteurs, alors que les fréquences de plus en plus élevées de ce type d'application exigent des résistances d'interconnexion inférieures à un seuil (typiquement 10 ohms voire moins). De telles résistances ne peuvent pas être mesurées par les technologies de test des résistances d'interconnexion inférieures à un seuil (typiquement 10 ohms voire moins). De telles résistances ne peuvent pas être mesurées par les technologies de test sans contact de l'art antérieur (test à faisceau d'électrons tel que décrit dans le document US 4 573 008, par utilisation d'un chemin de conduction électrique, par création d'un plasma ou par utilisation de l'effet photoélectrique simple).

En fait, aucune des technologies décrites ci-avant ne permet de faire circuler un courant d'un bout à l'autre d'un conducteur, sans accéder mécaniquement (en le touchant) à l'une et/ou à l'autre de ses extrémités, et aucune ne permet de mesurer de manière précise la résistance de ces conducteurs.

La présente invention se propose de remédier à ces problèmes. Elle vise également la charge de conducteurs (éjection d'électrons), et aussi à permettre à ces conducteurs de récupérer des électrons (injection ou absorption), et de ce fait, de se décharger (évolution négative de leur potentiel par absorption d'électrons), de manière à pouvoir utiliser ces deux modes pour contrôler individuellement le potentiel de chaque conducteur à tester, et de vérifier par la mise en place d'algorithmes, la conformité de leur interconnexion.

Ces objectifs sont atteints par la prévision d'un procédé pour l'établissement d'un courant électrique dans un conducteur, consistant :

- à disposer en regard et à proximité du conducteur une plaque munie d'une pluralité de zones conductrices susceptibles d'être portées individuellement à des potentiels électriques quelconques ajustables,
- à appliquer un faisceau de particules sur un premier point du conducteur pour lui arracher des électrons, et
- à injecter en parallèle des électrons en un second point du conducteur, produisant une circulation de courant électrique dans le conducteur entre le premier point et le second point.

Selon un premier mode de réalisation de l'invention, ledit faisceau de particules est un faisceau lumineux émis par une source de lumière ultraviolette, ayant une énergie suffisante pour arracher des électrons au conducteur.

Dans ce cas, le procédé selon l'invention peut comprendre les étapes consistant :

- à porter préalablement le conducteur à un premier potentiel,
- à porter une première zone conductrice de la plaque, située au voisinage du premier point du conducteur, à un second potentiel (V$^+$) prédéfini supérieur au premier potentiel, et
- à porter à un troisième potentiel inférieur au second potentiel des zones conductrices voisines de la première zone, de manière à ce que les électrons arrachés au conducteur par le faisceau lumineux soient canalisés vers la première zone conductrice par les zones conductrices voisines.

Selon une particularité de l'invention, l'injection d'électrons en le second point du conducteur consiste à porter à un potentiel voisin du premier potentiel une troisième zone conductrice de la plaque, située au voisinage dudit second point, ainsi que des zones voisines de celles-ci, puis en appliquant un faisceau de lumière ultraviolette sur la troisième zone conductrice.

A cet effet, la plaque peut comprendre une pluralité de zones conductrices, chacune de ces zones ayant une épaisseur telle qu'en leur appliquant un faisceau de lumière ultraviolette d'un côté de la plaque, elles émettent des électrons en direction d'un conducteur du substrat situé à proximité de l'autre côté de la plaque.

Selon un second mode d'exécution de l'invention, l'injection d'électrons en le second point du conducteur est effectuée à l'aide d'un ensemble d'une pluralité de micro-pointes, disposé en regard dudit second point sur la plaque, et comprenant une grille conductrice qui est portée à un potentiel supérieur au potentiel appliqué aux micro-pointes, pour émettre des électrons.

Dans ce cas, la plaque peut avantageusement comprendre une pluralité d'ensembles de micro-pointes répartis en réseau matriciel sur la plaque, chaque ensemble étant commandable individuellement pour émettre des électrons en direction d'un conducteur du substrat.

Selon un troisième mode d'exécution de l'invention, l'injection d'électrons en le second point du conducteur est effectuée à l'aide d'un réseau de plages conductrices réparties en pixels en contact avec une feuille en élastomère à conduction anisotrope dans une direction perpendiculaire à ladite surface, cette feuille en élastomère étant appliquée contre le conducteur, chaque plage conductrice étant susceptible d'être portée individuellement à un potentiel quelconque ajustable.

L'invention concerne également un procédé de test électrique de conducteurs disposés sur un substrat isolant, ce procédé comprenant une phase initiale de disposition en regard d'au moins une face d'un substrat d'une plaque munie en toute région voisine d'un conducteur du substrat de zones conductrices susceptibles d'être portées individuellement à des potentiels électriques quelconques ajustables, ce procédé comprenant une phase de test de continuité des conducteurs du substrat consistant pour chaque conducteur du substrat à établir un courant dans le conducteur conformément au procédé défini ci-avant.

Dans son principe, ce procédé consiste à contrôler de manière individuelle le potentiel des conducteurs du substrat à tester, par éjection / injection d'électrons, et à mesurer les flux de courants correspondant.

Ce procédé de test peut en outre consister à déterminer la résistance du conducteur entre le premier et le second point du conducteur, et à comparer la résistance ainsi déterminée à un seuil prédéfini, un défaut étant détecté si la résistance est supérieure audit seuil.

Ce procédé de test comprend avantageusement une phase de test d'isolement des conducteurs du substrat, consistant à :

- porter à un potentiel prédéfini tous les conducteurs du substrat, et
- pour chaque conducteur du substrat, à établir un flux d'électrons d'un point du conducteur vers une première zone conductrice de la plaque, située au voisinage du point du conducteur, pour porter le conducteur à un premier potentiel prédéterminé, ce flux étant établi par application du premier potentiel à la première zone conductrice, et d'un second potentiel prédéfini inférieur au premier potentiel à des zones conductrices de la plaque, voisines de la première zone, et par application d'un faisceau lumineux audit point du conducteur ; et à mesurer le courant de charge du conducteur qui doit tendre vers zéro au bout d'un temps prédéterminé si le conducteur est isolé.

Selon une particularité de l'invention, si un défaut d'isolement est détecté sur un conducteur au cours de la phase de test d'isolement, il comprend une phase de test d'isolement secondaire consistant à mesurer la résistance entre le conducteur en défaut et tous les autres conducteurs du substrat.

L'invention concerne également un dispositif de test électrique de conducteurs disposés sur un substrat isolant. Ce dispositif comprend :

- au moins une source de particules associée à des moyens de commande, pour émettre un faisceau de particules en direction d'un point quelconque déterminé d'un conducteur du substrat isolant, de manière à arracher des électrons dudit conducteur et ainsi augmenter son potentiel électrique,
- au moins une plaque, disposée en regard d'une face respective du substrat isolant, et comprenant des zones conductrices en toute région voisine de la verticale d'un conducteur du substrat 1 à tester,
- des moyens pour injecter des électrons en un point déterminé quelconque d'un conducteur sur le substrat isolant, et
- une centrale de commande et de mesure pour porter individuellement à des potentiels électriques quelconques ajustables les zones conductrices, et pour mesurer des courants et des tensions entre deux zones conductrices quelconques préalablement sélectionnées.

Avantageusement, la source de particules est une source de lumière ultraviolette.

Selon un premier mode de réalisation, ce dispositif comprend une pluralité de micro-sources laser réparties sur la surface de la plaque.

Avantageusement, chaque source de lumière ultraviolette est disposée à distance de la plaque et émet un faisceau dont l'inclinaison est ajustable autour d'un angle de 90° par rapport au plan de la plaque.

Selon un second mode de réalisation, ce dispositif comprend un réseau matriciel d'ensembles de micro-pointes disposés sur la plaque et commandées individuellement pour émettre des électrons en direction d'un quelconque des conducteurs du substrat.

Selon un troisième mode de réalisation, ce dispositif comprend un réseau de plages conductrices réparties en pixels au contact d'une feuille en élastomère à conduction anisotrope dans une direction perpendiculaire à ladite surface, cette feuille en élastomère étant appliquée contre le conducteur, chaque plage conductrice étant susceptible d'être portée individuellement à un potentiel quelconque ajustable.

Selon une particularité de l'invention, les moyens pour injecter des électrons comprennent une pluralité de sources d'électrons réparties selon un réseau matriciel et commandables individuellement par un adressage en ligne /colonne.

La centrale de commande et de mesure comprend de préférence des moyens d'adressage pour sélectionner les zones conductrices des plaques, à porter à un potentiel déterminé, et à partir desquelles le courant ou la tension sont mesurés.

Selon une particularité de l'invention, ce dispositif comprend une chambre à vide partiel (dans laquelle sont disposés le substrat isolant et chaque plaque.

Ces objets, caractéristiques et avantages ainsi que d'autres de la présente invention seront exposés plus en détail dans la description suivante de modes d'exécution préférés de l'invention, faite à titre non limitatif en relation avec les figures jointes parmi lesquelles :

- la figure 1 représente un substrat porteur de pistes conductrices, inséré dans un dispositif de test selon un premier mode de réalisation préféré de l'invention ;
- la figure 2 illustre en coupe transversale un dispositif de test selon un second mode de réalisation préféré de l'invention ;
- la figure 3 montre en vue de dessus le dispositif de test représenté sur la figure 2 ;
- la figure 4 montre en coupe transversale un dispositif de test selon un troisième mode de réalisation préféré de l'invention ;
- la figure 5 illustre un principe utilisé dans un dispositif de test selon un quatrième mode de réalisation préféré de l'invention ;
- la figure 6 montre en coupe transversale un dispositif de test selon le quatrième mode de réalisation préféré de l'invention ;
- la figure 7 montre une courbe d'un courant de test obtenu dans le dispositif représenté sur la figure 6 ;
- la figure 8 montre en coupe transversale un dispositif de test selon un cinquième mode de réalisation préféré de l'invention ;

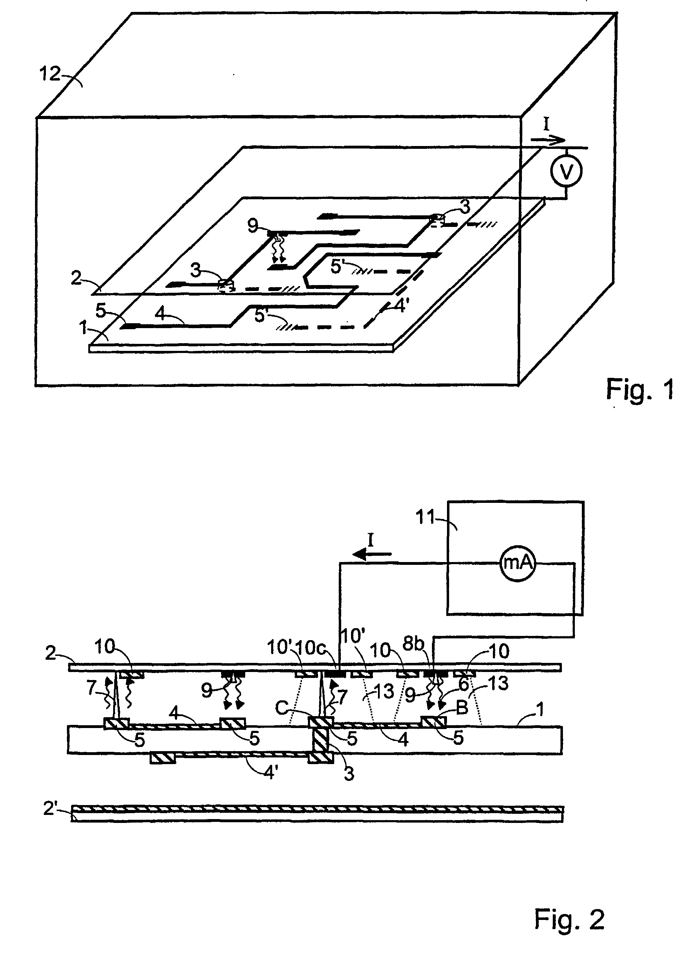

Les figures 1 à 3 montrent un substrat 1 possédant sur une face des conducteurs 4, pour lesquels l'accès électrique nécessaire selon la présente invention se fait au niveau de plages de contact 5. Le substrat peut également comprendre sur son autre face des conducteurs 4' et des plages de contact 5', les conducteurs 4 et 4' des deux faces pouvant être reliés par des trous métallisés 3.

La présente invention utilise au moins une source de lumière ultraviolette 7, 9. Elle s'appuie sur un dispositif spécifique appelé par la suite "plaque de décharge et de collecte" 2, 2', utilisant l'effet photoélectrique par stimulation par une source de rayons lumineux ultraviolets 7 ou 9.

Le dispositif de test selon l'invention comprend donc quatre principaux éléments :

A. au moins une plaque de décharge et de collecte 2, 2', constituée d'un substrat comprenant des zones conductrices 8, 10, recouvrant totalement ou partiellement le substrat à décharger, ces zones conductrices pouvant être portées individuellement à des potentiels électriques quelconques, positifs, nuls ou négatifs et non nécessairement identiques,
B. une ou plusieurs sources de lumière ultraviolette 7 ou 9,
C. une chambre à vide partiel 12 (typiquement de 1 millitorr), accueillant les plaques de décharge et de collecte décrites ci-dessus, ainsi que le substrat 1 et un châssis soutenant le tout,
D. une centrale de commande et de mesure 11 permettant le comptage des électrons (mesure de courant), l'imposition et la mesure de diverses tensions sur les plaques 2 et 2'. Cette centrale de mesure permet également par un adressage spécifique, de programmer des états souhaités des divers conducteurs des plaques 2 et 2', et de mesurer les signaux souhaités.

La plaque de décharge et de collecte 2 est disposée parallèlement au substrat 1 et en regard de la face du substrat à tester où se trouvent les conducteurs 4 et les plages de contact 5. Dans le cas ou des conducteurs 4' sont également présents sur l'autre face du substrat 1, une deuxième plaque de décharge et de collecte 2' peut être disposée parallèlement et en regard de cette face.

Selon l'invention, un faisceau de lumière ultraviolette 9 vient éjecter des électrons 6 d'une zone conductrice 8 de la plaque de décharge et de collecte 2. A cet effet, l'épaisseur de chaque zone conductrice 8 est légèrement supérieure à l'épaisseur de peau (50 à 100 Å) de la couche métallique formant la zone conductrice, de manière à ce que d'une part, le faisceau laser 9 n'atteigne pas les conducteurs 4 du substrat 1, et d'autre part, un nombre significatif d'électrons arrachés à la couche métallique traverse celle-ci pour atteindre le conducteur 4 visé. Les électrons ainsi arrachés sont alors captés par le conducteur 4 voisin de la verticale d'émission. Cette zone de captation peut elle-même être limitée par la création d'un couloir de circulation d'électrons 13, dans les environs de l'impact du faisceau, en mettant le conducteur 4 visé à un potentiel positif par rapport à la zone conductrice 8, et les autres conducteurs 4 du substrat ainsi que les zones conductrices voisines 8, 10, de la plaque 2, à un potentiel négatif.

La plaque de décharge et de collecte 2 selon la présente invention, est utilisée, contrairement à l'art antérieur, à la fois comme une source et un drain local d'électrons générés par effet photoélectrique.

A cet effet, elle comprend :

1. en toute région voisine de la verticale d'un conducteur 4 du substrat 1 à tester et du côté de celui-ci, des zones conductrices 8 programmables individuellement à un potentiel donné par la centrale de commande et de mesure 11, et susceptibles d'être bombardées par au moins une des sources lumineuses en vue d'émettre des électrons, lesquels sont absorbés par le conducteur 4 souhaité, au travers d'un couloir de circulation des électrons 13, pourvu que le potentiel du conducteur 4 visé soit supérieur à celui de la zone conductrice 8 émettrice,
2. en toute région voisine de la verticale d'un conducteur 4 du substrat 1 à tester, des zones conductrices 10, 10' dont le potentiel est indépendamment ajustable à une valeur donnée, de manière à pouvoir générer des couloirs de collecte d'électrons 13 et à collecter des électrons émis localement par les conducteurs 4 du substrat 1 au travers de ces couloirs, sans perte notoire d'électrons qui auraient pu aller rejoindre d'autres conducteurs voisins.

En d'autres termes, la plaque de décharge et de collecte 2 est conçue pour assurer les trois fonctions suivantes :

I. émettre localement des électrons vers un conducteur 4 donné du substrat 1 à tester, et mesurer le courant correspondant ;
II. réceptionner des électrons provenant d'un conducteur 4 donné du substrat 1 à tester, et mesurer le courant correspondant ;
III. réaliser des "couloirs" de circulation d'électrons 6 imposant à des électrons émis par la plaque 2 ou par le substrat 1 de suivre un chemin donné, de manière à contrôler soit leur absorption par un conducteur 4 donné du substrat 1, soit leur collecte par un point donné de la plaque 2. Ces couloirs sont réalisés par programmation à des potentiels répulsifs un nombre choisi de zones conductrices 10, 10' dont la géométrie va définir la base du couloir de circulation 13 autour du point d'émission 8 ou de collecte 10, ce couloir s'établissant de manière entre le substrat et la plaque, sensiblement perpendiculairement à ces derniers.

Les sources de lumière ultraviolette 7, 9 peuvent être intégrées dans la plaque de décharge et de collecte.

Il convient de noter que la direction des faisceaux issus des sources lumineuses 7, 9 est sensiblement perpendiculaire au plan de la plaque 2. Toutefois, dans certains modes de réalisation, on peut prévoir des dispositifs permettant d'incliner légèrement ces faisceaux dans un cône ayant pour axe la perpendiculaire à la plaque 2 au point d'émission.

La mesure par charge et décharge de conducteur, selon l'invention, peut être effectuée de la manière suivante :

Dans une phase initiale, l'ensemble des conducteurs 4 présents sur le substrat 1 est déchargé à un potentiel négatif $V^-$. Un moyen simple pour y parvenir est de programmer l'ensemble des zones conductrices 10 et 8 des plaques 2 et 2' à ce potentiel $V^-$, et de bombarder l'ensemble des zones conductrices 8 par une ou plusieurs sources lumineuses ultraviolettes, de manière à ce que les électrons correspondants de la zone métallique 8 soient éjectés vers les conducteurs 4 du substrat 1 jusqu'à ce que tous les conducteurs 4 atteignent ce potentiel $V^-$.

Dans une deuxième phase, lorsque l'on souhaite procéder à un test de continuité des équipotentielles du substrat 1 à tester, chaque conducteur 4 fait l'objet de la procédure suivante :

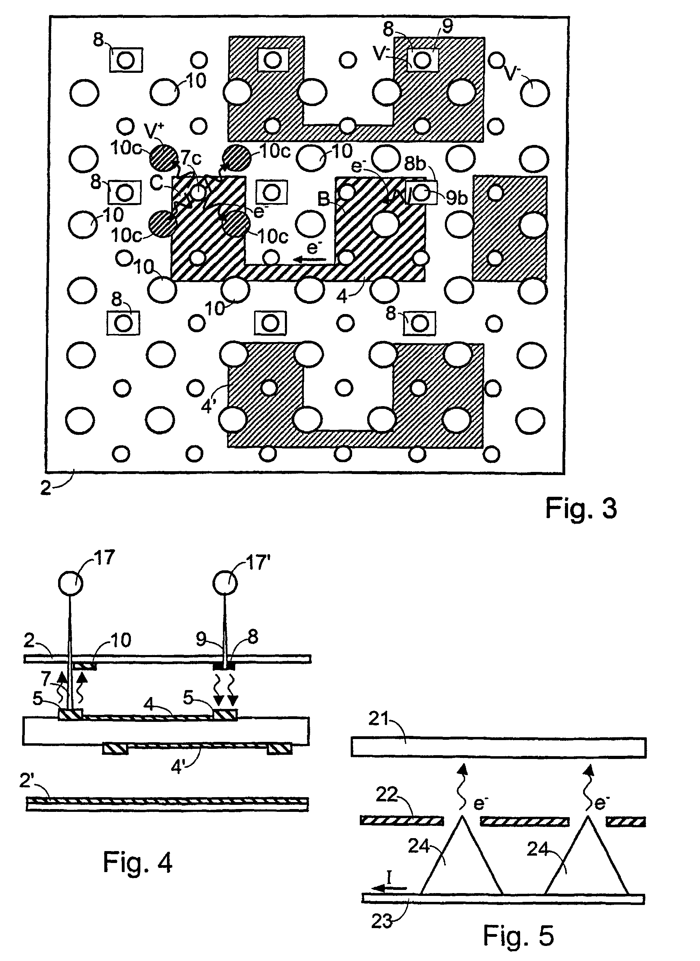

I. le conducteur 4 est chargé par bombardement par la source lumineuse ultraviolette 7, certaines zones conductrices 10c (hachurées sur la figure 3) de la plaque 2, à la périphérie de la verticale de la plage conductrice C à une extrémité du conducteur 4, étant au préalable programmées à la valeur $V^+$, créant ainsi un couloir de circulation d'électrons 13. Il en résulte une migration des électrons du conducteur 4 vers ces zones conductrices 10c et donc un début de charge du conducteur 4 qui voit son potentiel croître ;
II. en parallèle, le conducteur 4 est déchargé au voisinage de la plage B à une autre extrémité du conducteur 4, par injection d'électrons en appliquant la source lumineuse ultraviolette 9 sur une zone conductrice 8b de la plaque 2, voisine de la verticale de la plage B : le conducteur 4 faisant en parallèle l'objet d'une charge en un autre point, son potentiel doit être supérieur à V⁻, s'il ne présente pas de coupure.

Il en résulte un flux d'électrons de B vers C dans le conducteur 4, et donc la circulation d'un courant I de C vers B dans ce conducteur. Ce courant est en particulier une fonction f(R) de la résistance du conducteur entre B et C. La continuité du conducteur est déterminée si cette résistance est inférieure à un seuil prédéfini.

Le courant ainsi obtenu est de l'ordre de quelques dizaines de pA (jusqu'à une centaine de pA) pour une tension d'accélération des électrons comprise entre 10 et 50 V.

Ainsi, sur la figure 3 qui montre une vue de dessus de la plaque de décharge et de collecte 2, avec des conducteurs 4 et 4' en transparence, le bombardement de la zone conductrice 8b par la micro-source 9b entraîne l'apparition d'électrons au point B du conducteur 4 chargé positivement par le bombardement du conducteur 4 au point C par la source 7, ce qui provoque la circulation d'un courant I dans le conducteur 4 du substrat 1, et permet donc de mesurer la conformité de la résistance d'un point à un autre du conducteur 4 (test de continuité). Les quatre zones conductrices 10c pour cette mesure sont programmées à un potentiel V⁺ positif, permettant la collecte d'électrons vers la centrale de commande et de mesure 11, les autres zones conductrices voisines 10 étant quant à elles programmées à un potentiel négatif V⁻, de même que les zones conductrices 8, ce qui permet de repousser les électrons vers les seules issues possibles que sont les sources 10c.

Dans une troisième phase, lorsque l'on souhaite effectuer un test d'isolement, chaque conducteur 4 fait l'objet de la procédure suivante :

I. le conducteur 4 est chargé à un potentiel V⁺ par bombardement par la source lumineuse ultraviolette 7, les zones conductrices 10 de la plaque 2, à la périphérie de la verticale du point C' ayant été au préalable portées au potentiel V⁺, tandis que les autres sont portées au potentiel V⁻. Il s'en suit une migration des électrons du conducteur 4 vers les zones conductrices 10 au travers d'un couloir de circulation 13 ;

II. si le courant de charge ne se rapproche pas de zéro au bout d'un temps donné (au bout d'un certain temps, le potentiel du conducteur 4, s'il est isolé, doit se rapprocher de V⁺), cela signifie qu'il y a une fuite d'électrons vers d'autres conducteurs. Cette fuite peut être mesurée (courant I résiduel), ce qui permet de déterminer la valeur de la résistance de fuite R = (V⁺ - V⁻)/I.

Les deuxième et troisième phases sont ainsi répétées pour chaque conducteur 4, 4' du substrat 1 à tester.

La distance entre le substrat 1 et la plaque 2 n'est pas critique, car l'énergie d'accélération des électrons par la différence de potentiel est indépendante de la distance entre les deux électrodes. Par contre, elle est en partie définie par le mode de réalisation choisi.

Si un défaut d'isolement est détecté sur un conducteur au cours de la phase de test d'isolement, on peut procéder à une phase de test d'isolement secondaire consistant à mesurer la résistance entre le conducteur en défaut et tous les autres conducteurs 4 du substrat, de manière à localiser précisément entre quels conducteurs 4 se situe le défaut d'isolement.

Selon un premier mode de réalisation de la présente invention, illustré par la figure 3, la plaque de décharge et de collecte 2 est constituée de la juxtaposition de micro-sources de lumière ultraviolettes 7, 9, et de zones conductrices 10 dont le potentiel peut être ajusté de manière indépendante, certaines de ces micro-sources 9 étant recouvertes d'une fine couche de dépôt métallique 8, l'émission de la micro-source sur ce dépôt provoquant l'émission d'électrons. Cette fine couche de dépôt métallique présente une épaisseur de l'ordre de 150 Angströms, sachant que les électrons, dans le cadre de l'effet photoélectrique pénètrent dans le métal à une profondeur d'environ 50 à 100 Angströms.

Ces micro-sources peuvent être organisées en matrice selon un pas fin, par exemple de l'ordre de 0,1 mm, soit plusieurs millions de micro-sources laser si l'on considère des surfaces utiles de test de 300 x 200 mm environ.

Bien entendu, les zones conductrices 10 et les zones de dépôt métallique 8 peuvent être identiques.

Deux plaques 2, 2' peuvent être utilisées, de part et d'autre du substrat 1 (figure 2).

Les émissions par les sources lumineuses ultraviolettes peuvent se faire suivant un angle par rapport à la plaque 2 différent de 90 degrés, la valeur de cet angle étant programmable. On peut ainsi réduire le nombre nécessaire de sources, ou augmenter la résolution de test. A la limite, ce nombre peut être réduit à une ou deux sources 17 d'un côté ou de chaque côté du substrat (figure 4), selon la configuration des pistes conductrices 4, 4' à tester. Dans ce cas, les sources lumineuses sont placées à distance de la plaque 2, de manière à pouvoir éclairer l'ensemble du substrat au travers de la plaque 2, sous un angle incident de préférence inférieur à 20°.

Les sources de lumière ultraviolette sont par exemple de type laser YAG UV utilisant le 4ᵉᵐᵉ harmonique à 266 nm, émettant avec une puissance de l'ordre de 27 mW pulsée.

Les plaques 2, 2' sont avantageusement réalisées dans un matériau transparent aux ultraviolets, par exemple en silice.

Bien entendu, les plages conductrices 8, 10 des plaques de décharge et de collecte peuvent être identiques et utilisables à la fois pour collecter et émettre des électrons selon la valeur du potentiel qui leur est appliqué.

Alternativement, moyennant quelques aménagements, on peut utiliser comme sources d'électrons un ou plusieurs ensembles de micro-pointes permettant d'émettre un faisceau d'électrons, en lieu et place des sources laser utilisant l'effet photoélectrique.

Sur la figure 5, de telles ensembles de micro-pointes comprennent de manière connue, de fines pointes 24 en silicium réalisées sur un support 23, et une grille métallique 22 trouée au voisinage des sommets des micro-pointes. Si on applique une tension sur cette grille supérieure à celle des pointes, cela provoque, par effet tunnel ou de pointe, l'émission d'électrons auxquels est fournie une énergie cinétique. Ces électrons ayant franchi la barrière de potentiel des pointes, sont alors libres de se déplacer dans l'espace. Ces électrons sont ensuite recueillis par une anode 21, qui est typiquement un conducteur. Dans l'invention, ce conducteur correspond aux pistes métalliques 4, 4' du circuit imprimé à tester, que l'on peut ainsi alimenter sans contact en électrons.

Par comparaison à l'effet thermoïonique (lampe à incandescence) on peut qualifier ce dispositif de "cathode froide".

De telles ensembles ont été conçus pour réaliser des écrans plats dans lesquels un écran fluorescent est bombardé par les électrons émis par les micropointes.

Contrairement aux micro-pointes utilisées dans les écrans plats, l'invention propose d'utiliser ces micro-pointes dans un mode de polarisation normal.

De telles ensembles peuvent être fabriqués en des dimensions compatibles avec celles des circuits à tester.

Il faut cependant noter que comme dans le cas de matrices de micro-sources laser, il faut disposer d'un système de multiplexage spatial très dense, soit passer par un multiplexage ligne/colonne pour commander individuellement chaque micro-source ou chaque ensemble de micro-pointes.

Les micro-pointes ont une dimension voisine du micron et sont fabriquées selon des techniques de semi-conducteurs. On peut ainsi réaliser plusieurs milliers de ces micro-pointes dans un motif de 100 x 100 µm. Ces motifs peuvent être dessinés sur des surfaces aussi grandes que 500 x 500 mm. Le support 23 peut-être de la silice, matériau transparent aux UV.

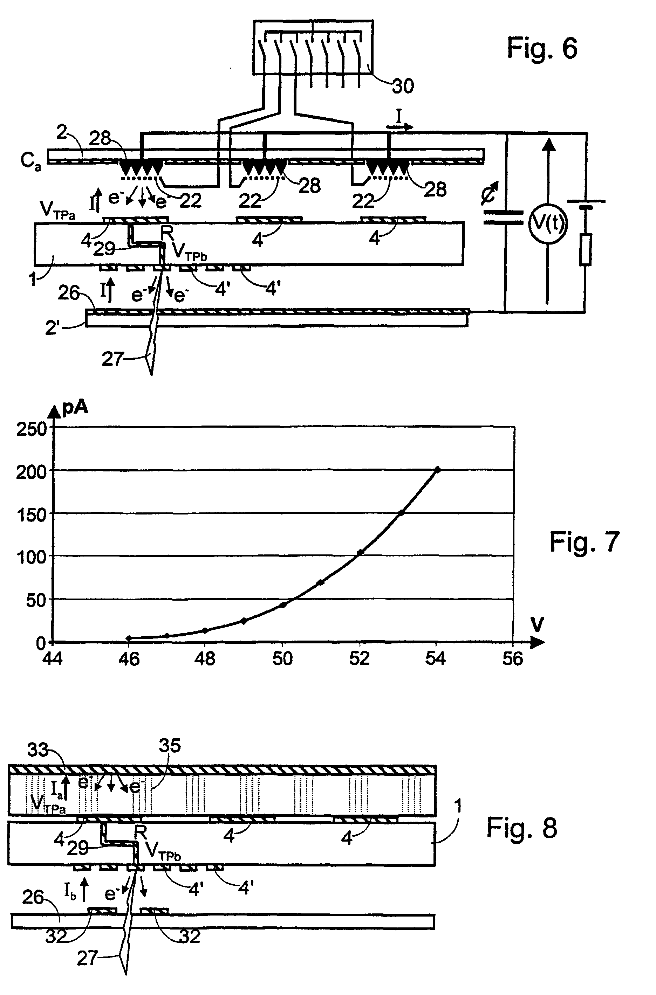

Le dispositif de test qui combine selon un mode de réalisation de l'invention l'effet photo-électrique aux micropointes est particulièrement adapté au test des circuits support de puces à semi-conducteur, communément appelés "chip carrier". C'est en fait un circuit imprimé de petite taille (typiquement 35 mm x 35 mm), présentant une géométrie particulière, très dense, réalisé avec les technologies de pointe du domaine de la fabrication de substrats. Dans un tel circuit représenté sur la figure 6, les équipotentielles présentent deux points de test 4, 4' interconnectés par un conducteur 29, l'un 4' formé sur la face inférieure avec un pas très fin, et l'autre 4 sur la face supérieure avec un pas plus large, entre 0,25 mm et plus de 0,5 mm.

Les chip carriers se présentent sous la forme de rubans de longueur typique de 150 mm. On peut donc envisager une surface utile de test de 200 x 200 mm maximum.

Ces remarques permettent d'envisager la description d'un dispositif de test sans contact à architecture simplifiée pour le test de "chip carriers".

Sur la figure 6, le dispositif de test comprend sur une surface par exemple de l'ordre de 200 mm x 200 mm, un réseau d'ensembles 28 de micro-pointes, répartis sur la plaque 2 suivant une configuration matricielle, par exemple au pas de 100 µm, les points de test étant disposés suivant un pas de 200 µm.

Les ensembles de micro-pointes peuvent être agencés de telle manière que leur courant d'alimentation soit commun à toutes, et que la commande de grille 30 (multiplexée selon un principe ligne/colonne selon la technologie standard utilisée pour les micro-pointes) suffit pour les rendre actives : il n'est pas nécessaire alors de multiplexer ni les collecteurs (un seul par face suffit), ni les micro-pointes : le circuit de mesure est donc élémentaire et facile à mettre en oeuvre.

La mesure de la résistance de continuité est par exemple effectuée en étudiant le transitoire de la charge d'une grosse capacité C : la pente de la charge donne la résistance recherchée.

Le test d'isolement peut être réalisé suivant la méthode suivante :

Dans une phase préalable, on vient bombarder (charger) toutes les équipotentielles d'une face par les micro-pointes, qui sont toutes mises à un même potentiel que l'on peut mesurer de l'autre côté, sur les points 4' par effet photoélectrique à l'aide d'un faisceau laser ultraviolet 27. A cet effet, on applique au collecteur 2' une tension donnée, et on vérifie régulièrement, à l'aide de courtes impulsions de lumière, que l'électrode ne collecte plus d'électrons. A ce moment, le potentiel de la plage testée est au potentiel (connu) du collecteur 2'. On peut ensuite rapidement vérifier que toutes les pistes sont à ce potentiel, en les bombardant à leur tour, jusqu'à ce que la plaque 2 ne collecte plus d'électrons. On établit ainsi une référence de potentiel pour toutes les plages.

Il convient de noter que cette phase peut être effectuée en parallèle sur un deuxième circuit, après avoir déchargé son prédécesseur, pendant que l'on teste le premier circuit.

Ensuite, on vient décharger localement une plage 4' par effet photoélectrique (on élève le potentiel du collecteur 2' de 40 V par exemple). Une fois la plage déchargée, on observe l'évolution de son potentiel pendant quelques μs, puis on la bombarde de nouveau pour voir si on récupère des électrons. Si son potentiel évolue sans qu'on bombarde la plage, cela révèle une fuite d'électrons, et donc un problème d'isolement.

Dans une phase secondaire, on peut ensuite mesurer la résistance en défaut, en balayant toutes les plages, selon la méthode de mesure réelle de résistance exposée ci-dessus pour la continuité.

Puis on recharge la plage 4 en commandant l'ensemble de micro-pointes situé en regard de la plage 4' à laquelle elle est reliée et on répète les opérations décrites ci-avant pour un autre conducteur 29.

La figure 7 montre un exemple de courbe de courant donnant la valeur moyenne du courant mesuré en fonction de la tension d'accélération des électrons (tension de la grille 22), lorsque l'on établit un circuit combinant une liaison par effet photoélectrique et une liaison par effet de micro-pointes, la tension V des micro-pointes étant maintenue constante à 48 V. Cette courbe montre qu'il existe un optimum de tension au voisinage de 54 Volts, pour lequel la valeur moyenne du courant peut atteindre 200 pico-ampères (pA), tandis que le courant en valeur crête peut atteindre des valeurs nettement supérieures.

Cette courbe prouve qu'il est possible de faire circuler un courant dans un conducteur sans contact avec celui-ci. Il peut aussi être envisagé d'amplifier le courant par tout moyen approprié.

Ce procédé de test peut bien entendu s'appliquer à des circuits quelconques dans lesquels les équipotentielles peuvent avoir des terminaisons sur n'importe quelle face du circuit. Il suffit pour cela de prévoir un réseau d'ensembles de micro-pointes et au moins une source laser ultraviolette, en regard de chaque face du circuit, ce qui est rendu possible par le fait que les matrices de micro-pointes peuvent être formées sur un substrat en silice qui est transparent aux ultraviolets.

Dans une variante préférée de l'invention, représentée sur la figure 8, le réseau d'ensembles de micro-pointes est remplacé par un réseau de plages conductrices 33 réparties en pixels suivant un pas de l'ordre de 100 μm. La connexion de ce réseau avec les conducteurs 4, 4' du substrat, est réalisée par une feuille 34 en élastomère à conduction anisotrope, tel que celui fabriqué par la société japonaise Japan Synthetic Rubber. Cette feuille 34 comprend des particules conductrices 35 qui sont noyées dans l'élastomère, de manière à ce que lorsqu'elle est comprimée, les particules se touchent et conduisent dans une direction perpendiculaire au plan du réseau de conducteurs 33. Les pixels du réseau de plages conductrices sont individuellement programmables en tension par multiplexage en ligne / colonne.

Un tel réseau de conducteurs est particulièrement adapté pour le test de "chip carrier". En effet, le pas des pixels permet d'accéder individuellement au points de test qui sont répartis suivant un pas de 150 à 200 μm. Sur l'autre face du "chip carrier", les plages de contacts sont déchargées par effet photoélectrique, au moyen d'une source laser ultraviolette qui émet un faisceau 27 sur une plage de contact 4' sélectionnée, les électrons ainsi arrachés étant recueillis par une plaque de collecte 2' munie à cet effet de plages conductrices 32.

Pour effectuer un test de continuité du conducteur 29 du "chip carrier", la feuille conductrice 33 du réseau de conducteurs est portée à un potentiel négatif qui est transmis aux conducteurs 4 du "chip carrier" par l'élastomère 34. Il suffit ensuite de tester les unes après les autres les plages de contact 4' situées sur l'autre face du "chip carrier" grâce au faisceau laser 27. Si la plage de contact 4' est reliée par un conducteur 29 à un conducteur 4, il s'établit un courant $I_a$ entre le conducteur 4 et la feuille conductrice 33, et $I_b$ entre les plages 4' et 32. La mesure de ce courant permet de déterminer la résistance de continuité du conducteur 29 entre les plages 4 et 4'.

Pour effectuer un test d'isolement, tous les pixels du réseau de conducteurs 33 sont portés à un potentiel négatif sauf ceux au voisinage de la plage 4 à tester. On charge ensuite la plage 4' en vis-à-vis sur la face inférieure avec le faisceau laser 27, jusqu'à ce que son potentiel atteigne une valeur positive donnée qui est celle du collecteur 32. Quelques microsecondes plus tard, on envoie à nouveau le faisceau laser sur cette plage 4'. Si des électrons sont recueillis par le collecteur 32 (si un courant passe entre le réseau de conducteurs 33 et le collecteur 32), cela signifie qu'il s'est produit une migration d'électrons d'autres pistes vers la piste testée, et donc qu'il y a un défaut d'isolement. Une résistance de fuite globale peut être déterminée à partir du temps de charge du conducteur et de la surface de celui-ci.

De même une résistance de fuite locale peut être déterminée en mesurant la résistance entre la piste testée et chacune des autres pistes du substrat à tester.

La possibilité de contrôle de la charge et de la décharge d'un conducteur donné figurant parmi d'autres sur un substrat, tel un circuit imprimé, entraîne la possibilité de vérification de la qualité de l'interconnexion, ou en d'autres termes son test, et ce pour les substrats les plus complexes, sans contact mécanique, sans outillage spécifique, à des vitesses de traitement compatibles avec les besoins en production, pour des coûts nettement inférieurs à ceux enregistrés aujourd'hui, ce qui rend cette application très intéressante du point de vue industriel, pour le test de circuits nus, tels que les circuits imprimés pour téléphones cellulaires, les circuits équipés de composants, ainsi que certaines applications dans le domaine du semi-conducteur pour lesquelles la possibilité de mesurer soit le potentiel, soit la fréquence, soit de mesurer ou d'injecter des courants électriques présente un intérêt. Il en effet possible, avec la méthode décrite dans le cadre de cette invention, puisqu'elle permet de suivre précisément l'évolution du potentiel d'un conducteur, de déterminer la forme du signal correspondant, et donc sa fréquence s'il s'agit d'un signal alternatif. Cette propriété pourra donc être utilisée pour le test fonctionnel de cartes équipées de composants, consistant par exemple en l'examen de la réponse de certains signaux par rapport à un stimulus donné.

## Revendications

1. Procédé pour établir un courant électrique dans un conducteur (4), sans contact physique avec ce dernier, **caractérisé en ce qu'**il consiste ;

   - à disposer en regard et à proximité du conducteur (4) une plaque (2) munie d'une pluralité de zones conductrices (8, 10) susceptibles d'être portées individuellement à des potentiels électriques quelconques ajustables,
   - à appliquer un faisceau de particules (7) sur un premier point (C) du conducteur (4) pour lui arracher des électrons, et
   - à injecter en parallèle des électrons en un second point (B) du conducteur (4), produisant une circulation de courant électrique dans le conducteur (4) entre le premier point (C) et le second point (B).

2. Procédé selon la revendication 1, **caractérisé en ce que** ledit faisceau de particules est un faisceau lumineux (7) émis par une source de lumière ultraviolette, ayant une énergie suffisante pour arracher des électrons au conducteur (4).

3. Procédé selon la revendication 2, **caractérisé en ce qu'**il comprend en outre des étapes consistant:

   - à porter préalablement le conducteur (4) à un premier potentiel (V-),
   - à porter une première zone conductrice (10c) de la plaque (2), située au voisinage du premier point (C) du conducteur, à un second potentiel (V+) prédéfini supérieur au premier potentiel (V-), et
   - à porter à un troisième potentiel (V=) inférieur au second potentiel (V+) des zones conductrices voisines (10') de la première zone (10c), de manière à ce que les électrons arrachés au conducteur (4) par le faisceau lumineux (7) soient canalisés vers la première zone conductrice par les zones conductrices voisines.

4. Procédé selon la revendication 3, **caractérisé en ce que** l'injection d'électrons en le second point (B) du conducteur (4) consiste à porter à un potentiel voisin du premier potentiel (V-) une troisième zone conductrice (8b) de la plaque (2), située au voisinage dudit second point, ainsi que des zones voisines (8, 10) de celles-ci, puis en appliquant un faisceau de lumière ultraviolette. (9) sur la troisième zone conductrice (8b).

5. Procédé selon la revendication 4, **caractérisé en ce que** la plaque (2) comprend une pluralité de zones conductrices (8), chacune de ces zones ayant une épaisseur telle qu'en leur appliquant un faisceau de lumière ultraviolette (9) d'un côté de la plaque (2), elles émettent des électrons en direction d'un conducteur (4) du substrat (1) situé à proximité de l'autre côté de la plaque.

6. Procédé selon la revendication 3, **caractérisé en ce que** l'injection d'électrons en le second point (B) du conducteur est effectuée à l'aide d'un ensemble (28) d'une pluralité de micro-pointes (24), disposé en regard dudit second point sur la plaque (2), et comprenant une grille conductrice (22) qui est portée à un potentiel supérieur au potentiel appliqué aux micro-pointes (24), pour émettre des électrons.

7. Procédé selon la revendication 6, **caractérisé en ce que** la plaque (2) comprend une pluralité d'ensembles (28) de micro-pointes répartis en réseau matriciel sur la plaque (2), chaque ensemble étant commandable individuellement pour émettre des électrons en direction d'un conducteur (4) du substrat (1).

8. Procédé selon la revendication 3, **caractérisé en ce que** l'injection d'électrons en le second point du conducteur est effectuée à l'aide d'un réseau de plages conductrices réparties en pixels en contact avec une feuille en élastomère (35) à conduction anisotrope dans une direction perpendiculaire à ladite surface, cette feuille en élastomère étant appliquée contre le conducteur (4), chaque plage conductrice étant susceptible d'être portée individuellement à un potentiel quelconque ajustable.

9. Procédé de test électrique de conducteurs disposés sur un substrat isolant, **caractérisé en ce qu'**il comprend une phase initiale de disposition en regard d'au moins une face d'un substrat d'une plaque (2) munie en toute région voisine d'un conducteur (4, 4') du substrat (1) de . zones conductrices (8, 10) susceptibles d'être portées individuellement à des potentiels électriques quelconques ajustables, ce procédé comprenant une phase de test de continuité des conducteurs du substrat consistant pour chaque conducteur du substrat à établir un courant dans le conducteur conformément au procédé selon l'une quelconque des revendications 1 à 8, et à mesurer le courant ainsi établi.

10. Procédé de test selon la revendication 9, **caractérisé en ce qu'**il consiste en outre à déterminer la résistance du conducteur (4) entre le premier (C) et le second point (B) du conducteur, et à comparer la résistance ainsi déterminée à un seuil prédéfini, un défaut étant détecté si la résistance est supérieuré audit seuil.

11. Procédé de test selon la revendication 9 ou 10, **caractérisé en ce qu'**il comprend en outre une phase de test d'isolement des conducteurs du substrat, consistant à :

   - porter à un potentiel (V-) prédéfini tous les conducteurs (4, 4') du substrat (1), et
   - pour chaque conducteur (4) du substrat (1), à établir un flux d'électrons (6) d'un point (C) du conducteur vers une première zone conductrice (10c) de la plaque (2), située au voisinage du point du conducteur, pour porter le conducteur à un premier potentiel (V-) prédéterminé, ce flux étant établi par application du premier potentiel (V-) à la première zone conductrice (10c), et d'un second potentiel (V+) prédéfini inférieur au premier potentiel à des zones conductrices (10') de la plaque, voisines de la première zone (10c), et par application d'un faisceau lumineux (7) audit point du conducteur ; et à mesurer le courant de charge du conducteur (4) qui doit tendre vers zéro au bout d'un temps prédéterminé si le conducteur est isolé.

12. Procédé de test selon la revendication 11, **caractérisé en ce que** si un défaut d'isolement est détecté sur un conducteur au cours de la phase de test d'isolement, il comprend une phase de test d'isolement secondaire consistant à mesurer la résistance entre le conducteur en défaut et tous les autres conducteurs (4) du substrat.

13. Dispositif de test électrique de conducteurs disposés sur un substrat isolant, **caractérisé en ce qu'**il comprend :

   - au moins une source de particules (17, 17') associée à des moyens de commande (11), pour émettre un faisceau de particules en direction d'un point quelconque déterminé d'un conducteur (4) du substrat isolant (1), de manière à arracher des électrons dudit conducteur et ainsi augmenter son potentiel électrique,
   - au moins une plaque (2, 2'), disposée en regard d'une face respective du substrat isolant, et comprenant des zones conductrices (8, 10) en toute région voisine de la verticale d'un conducteur (4, 4') du substrat (1) à tester,
   - des moyens pour injecter des électrons en un point (C) déterminé quelconque d'un conducteur (4, 4') sur le substrat isolant (1), et
   - une centrale de commande et de mesure (11) pour porter individuellement à des potentiels électriques quelconques ajustables les zones conductrices (8, 10), et pour mesurer des courants et des tensions entre deux zones conductrices (8, 10) quelconques préalablement sélectionnées.

14. Dispositif selon la revendication 13, **caractérisé en ce que** la source de particules est une source de lumière ultraviolette (17, 17').

15. Dispositif selon la revendication 13 ou 14, **caractérisé en ce qu'**il comprend une pluralité de micro-sources laser réparties sur la surface de la plaque (2, 2').

16. Dispositif selon la revendication 14, **caractérisé en ce que** chaque source de lumière ultraviolette (17, 17') est disposée à distance de la plaque (2) et émet un faisceau dont l'inclinaison est ajustable autour d'un angle de 90° par rapport au plan de la plaque (2, 2').

17. Dispositif selon l'une quelconque des revendications 13 à 16, **caractérisé en ce qu'**il comprend un réseau matriciel d'ensembles (24) de micro-pointes disposés sur la plaque (2, 2') et commandées individuellement pour émettre des électrons en direction d'un quelconque des conducteurs (4) du substrat (1).

18. Dispositif selon la revendication 13, **caractérisé en ce qu'**il comprend un réseau (33) de plages conductrices réparties en pixels au contact d'une feuille (35) en élastomère à conduction anisotrope dans une direction perpendiculaire à ladite surface, cette feuille en élastomère étant appliquée contre le conducteur (4), chaque plage conductrice étant susceptible d'être portée individuellement à un potentiel quelconque ajustable.

19. Dispositif selon l'une quelconque des revendications 13 à 18, **caractérisé en ce que** les moyens pour injecter des électrons comprennent une pluralité de sources d'électrons, réparties selon un réseau matriciel et commandables individuellement par un adressage en ligne /colonne.

20. Dispositif selon l'une quelconque des revendications 13 à 19, **caractérisé en ce que** la centrale de commande et de mesure (11) comprend des moyens d'adressage pour sélectionner les zones conductrices (8, 10) des plaques (2, 2'), à porter à un potentiel déterminé, et à partir desquelles le courant ou la tension sont mesurés.

21. Dispositif selon l'une quelconque des revendications 13 à 20, **caractérisé en ce qu'**il comprend une chambre à vide partiel (12) dans laquelle sont disposés le substrat isolant (1) et chaque plaque (2, 2').

**Patentansprüche**

1. Verfahren zur Schaffung eines elektrischen Stroms in einem Leiter (4), ohne physischen Kontakt mit letzterem, **dadurch gekennzeichnet, dass** es umfasst:

   - Anordnen einer Platte (2) gegenüber und in der Nähe vom Leiter (4), welche mit einer Vielzahl von leitenden Zonen (8, 10) ausgestattet ist, die einzeln auf beliebige, einstellbare elektrische Potentiale gebracht werden können,

   - Anwenden eines Partikelstrahls (7) auf einen ersten Punkt (C) des Leiters (4), um ihm Elektronen zu entreißen, und

   - paralleles Injizieren von Elektronen an einem zweiten Punkt (B) des Leiters (4), um eine Zirkulation von elektrischem Strom im Leiter (4) zwischen dem ersten Punkt (C) und dem zweiten Punkt (B) zu erzeugen.

2. Verfahren nach Anspruch 1, **dadurch gekennzeichnet, dass** der Partikelstrahl ein Lichtstrahl (7) ist, der durch eine ultraviolette Lichtquelle ausgesendet wird, mit einer Energie, die ausreichend ist um dem Leiter (4) Elektronen zu entreißen.

3. Verfahren nach Anspruch 2, **dadurch gekennzeichnet, dass** es außerdem Schritte umfasst:

   - den Leiter (4) zunächst auf ein erstes Potential (V-) bringen,

   - eine erste leitende Zone (10c) der Platte (2), die sich in der Nähe des ersten Punkts (C) des Leiters befindet, auf ein vorbestimmtes zweites Potential (V+) bringen, das größer als das erste Potential (V-) ist,

   - leitende Zonen (10'), welche zur ersten Zone (10c) benachbart sind, auf ein drittes Potential (V) bringen, damit die durch den Lichtstrahl (7) dem Leiter (4) entrissenen Elektronen durch die benachbarten leitenden Zonen zur ersten leitenden Zone kanalisiert werden.

4. Verfahren nach Anspruch 3, **dadurch gekennzeichnet, dass** die Injektion von Elektronen an dem zweiten Punkt (B) des Leiters (4) umfasst, eine dritte leitende Zone (8b) der Platte, die sich in der Nähe des zweiten Punkts befindet, auf ein zum ersten Potential (V-) benachbartes Potential zu bringen, genauso wie dazu benachbarte Zonen (8, 10), und dann Anwenden eines ultravioletten Lichtstrahls (9) auf die dritte leitende Zone (8b).

5. Verfahren nach Anspruch 4, **dadurch gekennzeichnet, dass** die Platte (2) eine Vielzahl von leitenden Zonen (8) umfasst, wobei jede dieser Zonen eine Dicke hat, so dass sie beim Anwenden eines ultravioletten Lichtstrahls (9) von einer Seite der Platte (2) her, Elektronen in Richtung eines Leiters (4) des Substrats (1) abgeben, der sich in der Nähe der anderen Seite der Platte befindet.

6. Verfahren nach Anspruch 3, **dadurch gekennzeichnet, dass** die Injektion von Elektronen an dem zweiten Punkt (B) des Leiters mit Hilfe einer Menge (28) einer Vielzahl von Mikropunkten (24) bewirkt wird, die gegenüber dem zweiten Punkt auf der Platte (2) angeordnet sind, und ein leitendes Gitter (22) umfassen, welches auf ein Potential gebracht wird, das größer als das an die Mikropunkte (24) angelegte Potential ist, um Elektronen auszusenden.

7. Verfahren nach Anspruch 6, **dadurch gekennzeichnet, dass** die Platte (2) eine Vielzahl von Mengen (28) von Mikropunkten umfasst, die in einem Matrixgitter auf der Platte (2) angeordnet verteilt sind, wobei jede Menge einzeln ansteuerbar ist, um Elektronen in Richtung eines Leiters (4) des Substrats (1) auszusenden.

8. Verfahren nach Anspruch 3, **dadurch gekennzeichnet, dass** die Injektion von Elektronen in dem zweiten Punkt des Leiters bewirkt wird mit Hilfe eines Netzwerks von leitenden Bereichen, die in Pixeln verteilt sind, in Kontakt mit einer Elastomerfolie (35) mit anisotroper Leitfähigkeit in eine zur Oberfläche senkrechten Richtung, wobei die Elastomerfolie gegen den Leiter (4) appliziert ist, und jeder leitende Bereich einzeln auf ein beliebiges, einstellbares Potential gebracht werden kann.

9. Verfahren zum elektrischen Testen von Leitern, die auf einem isolierenden Substrat angeordnet sind, **dadurch gekennzeichnet, dass** es eine Initialphase umfasst, um gegenüber mindestens einer Fläche eines Substrats eine Platte 2 anzuordnen, die in jedem zu einem Leiter (4, 4') des Substrats (1) benachbarten Gebiet mit leitenden Zonen (8, 10) ausgestattet ist, die einzeln auf beliebige, einstellbare elektrische Potentiale gebracht werden können, wobei das Verfahren eine Phase zum Testen der Durchgängigkeit der Leiter des Substrats umfasst, das umfasst für jeden Leiter des Substrats einen Strom im Leiter gemäß einem Verfahren nach einem der Ansprüche 1 bis 8 zu schaffen, und den so geschaffenen Strom zu messen.

10. Testverfahren nach Anspruch 9, **dadurch gekennzeichnet, dass** es außerdem darin besteht, den Widerstand des Leiters (4) zwischen dem ersten (C) und dem zweiten Punkt (B) des Leiters zu bestimmen, und den so bestimmten Widerstand mit einer vorbestimmten Schwelle zu vergleichen, wobei ein Fehler festegestellt wird, wenn der Widerstand größer als die Schwelle ist.

11. Testverfahren nach Anspruch 9 oder 10, **dadurch gekennzeichnet, dass** es außerdem eine Phase zum Testen der Isolierung der Leiter des Substrats umfasst, umfassend:

    - Bringen aller Leiter (4, 4') des Substrats (1) auf ein vorbestimmtes Potential (V-), und

    - für jeden Leiter (4) des Substrats (1), Schaffen eines Elektronenflusses (6) von einem Punkt (C) des Leiters zu einer ersten leitenden Zone (10c) der Platte (2), die sich in der Nähe des Punkts des Leiters befindet, um den Leiter auf ein erstes vorbestimmtes Potential (V-) zu bringen, wobei der Fluss geschaffen wird durch Anlegen des ersten Potentials (V-) an die erste leitende Zone (10c), und eines vorbestimmten zweiten Potentials (V+), das kleiner ist als das erste Potential, an leitende Zonen (10') der Platte, die zur ersten Zone (10c) benachbart sind, und durch Anwenden eines Lichtstrahls (7) auf den Punkt des Leiters, und Messen des Ladungsstroms des Leiters (4), der gegen null tendieren muss am Ende einer vorbestimmten Zeit, wenn der Leiter isoliert ist.

12. Testverfahren nach Anspruch 11, **dadurch gekennzeichnet, dass** wenn ein Isolierfehler auf einem Leiter im Laufe der Phase des Testens der Isolierung erfasst wird, es eine sekundäre Phase des Testens der Isolierung umfasst, die umfasst, den Widerstand zwischen dem fehlerhaften Leiter und allen anderen Leitern (4) des Substrats zu messen.

13. Vorrichtung zum elektrischen Testen von Leitern, die auf einem isolierenden Substrat angeordnet sind, **dadurch gekennzeichnet, dass** sie umfasst:

    - mindestens eine Partikelquelle (17, 17'), die mit Befehlsmitteln (11) in Beziehung steht, um einen Partikelstrahl in Richtung eines beliebigen bestimmten Punkts eines Leiters (4) des isolierenden Substrats (1) auszusenden um dem Leiter Elektronen zu entreißen und somit sein elektrisches Potential zu vergrößern,

    - mindestens eine Platte (2, 2'), die gegenüber einer entsprechenden Fläche des isolierenden Substrats angeordnet ist, umfassend leitende Zonen (8, 10), in jedem benachbarten Gebiet der Vertikalen eines Leiters (4, 4') des Substrats (1), der zu testen ist,

    - Mittel zum Injizieren von Elektronen an einem beliebigen bestimmten Punkt (C) eines Leiters (4, 4') auf dem isolierenden Substrat (1), und

    - eine Zentrale zum Steuern und Messen (11), um die leitenden Zonen (8, 10) einzeln auf beliebige, einstellbare elektrische Potentiale zu bringen, und um Ströme und Spannungen zwischen zwei vorher gewählten, beliebigen leitenden Zonen (8,10) zu messen.

14. Vorrichtung nach Anspruch 13, **dadurch gekennzeichnet, dass** die Partikelquelle eine ultraviolette Lichtquelle (17, 17') ist.

15. Vorrichtung nach Anspruch 13 oder 14, **dadurch gekennzeichnet, dass** sie eine Vielzahl von Laser-Mikroquellen umfasst, die auf der Oberfläche der Platte (2, 2') angeordnet sind.

16. Vorrichtung nach Anspruch 14, **dadurch gekennzeichnet, dass** jede ultraviolette Lichtquelle (17, 17') zur Platte (2) beabstandet angeordnet ist, und einen Strahl aussendet, dessen Neigung um einen Winkel von 90° gegenüber der Ebene der Platte (2, 2') herum einstellbar ist.

17. Vorrichtung nach einem der Ansprüche 13 bis 16, **dadurch gekennzeichnet, dass** er ein Matrixnetzwerk von Mengen (24) von Mikropunkten umfasst, die auf der Platte (2, 2') angeordnet sind, und einzeln ansteuerbar sind, um Elektronen in Richtung eines beliebigen Leiters (4) des Substrats (1) auszusenden.

18. Vorrichtung nach Anspruch 13, **dadurch gekennzeichnet, dass** sie ein Netzwerk (33) aus leitenden Bereichen umfasst, die in Pixeln verteilt sind, in Kontakt mit einer Elastomerfolie (35), mit anisotroper Leitfähigkeit in einer zur Oberfläche senkrechten Richtung, wobei die Elastomerfolie gegen den Leiter (4) appliziert ist, und jeder leitfähige Bereich einzeln auf ein beliebiges, einstellbares Potential gebracht werden kann.

19. Vorrichtung nach einem der Ansprüche 13 bis 18, **dadurch gekennzeichnet, dass** die Mittel zum Injizieren von Elektronen eine Vielzahl von Elektronenquellen umfassen, die in einem Matrixnetzwerk verteilt sind, und einzeln ansteuerbar sind durch eine Zeilen/Spalten-Adressierung.

20. Vorrichtung nach einem der Ansprüche 13 bis 19, **dadurch gekennzeichnet, dass** die Zentrale zum Befehlen und Messen (11) Adressierungsmittel umfasst, um die leitenden Zonen (8, 10) der Platten (2, 2') auszuwählen, auf ein bestimmtes Potential zu bringen und wonach der Strom oder die Spannung gemessen werden.

21. Vorrichtung nach einem der Ansprüche 13 bis 20, **dadurch gekennzeichnet, dass** sie eine teilweise evakuierte Kammer (12) umfasst, in welcher das isolierende Substrat (1) und jede Platte (2, 2') angeordnet sind.

**Claims**

1. A method for establishing an electric current in a conductor (4), without physical contact therewith, **characterised in that** it consists in:

   - arranging opposite and in proximity to conductor (4) a plate (2) equipped with a plurality of conductive areas (8, 10) capable of being individually charged to any adjustable electric potentials,

   - applying a beam of particles (7) onto a first point (C) of conductor (4) to extract electrons therefrom, and

   - injecting, in parallel, electrons into a second point (B) of conductor (4), producing a flow of electric current in conductor (4) between first point (C) and second point (B).

2. The method according to Claim 1, **characterised in that** said beam of particles is a light beam (7) emitted by an ultraviolet light source having sufficient energy to extract electrons from conductor (4).

3. The method according to Claim 2, **characterised in that** it further comprises steps of:

   - precharging conductor (4) to a first potential (V-),

   - charging a first conductive area (10c) of plate (2), situated in the vicinity of first point (C) of the conductor, to a second predefined potential (V+) greater than first potential (V-), and

   - charging conductive areas (10') close to first area (10c) to a third potential (V=) lower than second potential (V+), such that the electrons extracted from conductor (4) by light beam (7) are channelled towards the first conductive area by the adjacent conductive areas.

4. The method according to Claim 3, **characterised**

**in that** the injection of electrons into second point (B) of conductor (4) consists in charging to a potential close to first potential (V-) a third conductive area (8b) of plate (2), situated in the vicinity of said second point, as well as areas (8, 10) adjacent thereto, then in applying an ultraviolet light beam (9) onto third conductive area (8b).

5. The method according to Claim 4, **characterised in that** plate (2) comprises a plurality of conductive areas (8), each of these areas having a thickness such that, when applying an ultraviolet light beam (9) thereto on one side of plate (2), these areas emit electrons in the direction of a conductor (4) of substrate (1) situated in proximity to the other side of the plate.

6. The method according to Claim 3, **characterised in that** the injection of electrons into second point (B) of the conductor is carried out using a set (28) of a plurality of micropoints (24), arranged opposite said second point on plate (2), and comprising a conductive grid (22) which is charged to a potential greater than the potential applied to micropoints (24) in order to emit electrons.

7. The method according to Claim 6, **characterised in that** plate (2) comprises a plurality of sets (28) of micropoints divided into a matrix network on plate (2), each set being individually controllable in order to emit electrons in the direction of a conductor (4) of substrate (1).

8. The method according to Claim 3, **characterised in that** the injection of electrons into the second point of the conductor is carried out using a network of conductive regions divided into pixels in contact with an anisotropically conductive, elastomer sheet (35) in a direction perpendicular to said surface, this elastomer sheet being applied against conductor (4), each conductive region capable of being individually charged to any adjustable potential.

9. An electrical test method for conductors arranged on an insulating substrate, **characterised in that** it comprises an initial stage of arranging opposite at least one face of a substrate a plate (2) equipped, in any zone adjacent to a conductor (4, 4') of substrate (1), with conductive areas (8, 10) capable of being individually charged to any adjustable electric potentials, this method comprising a continuity test stage for the conductors of the substrate consisting, for each conductor of the substrate, in establishing a current in the conductor in accordance with the method according to any one of Claims 1 to 8, and in measuring the current produced in this manner.

10. The test method according to Claim 9, **character-**

**ised in that** it further consists in determining the resistance of conductor (4) between first (C) and second point (B) of the conductor, and in comparing the resistance determined in this manner to a predefined threshold, a fault being detected if the resistance is greater than said threshold.

11. The test method according to Claim 9 or 10, **characterised in that** it further comprises an insulation test stage for the conductors of the substrate, consisting in:

   - charging all of conductors (4, 4') of substrate (1) to a predefined potential (V-), and

   - establishing, for each conductor (4) of substrate (1), a stream of electrons (6) from a point (C) of the conductor towards a first conductive area (10c) of plate (2), situated in the vicinity of the point of the conductor, in order to charge the conductor to a first predetermined potential (V-), this stream being established by applying first potential (V-) to first conductive area (10c), and a second predefined potential (V+) lower than the first potential to conductive areas (10') of the plate which are adjacent to first area (10c), and by applying a light beam (7) to said point of the conductor; and in measuring the load current of conductor (4) which must tend to zero after a predetermined period of time if the conductor is insulated.

12. The test method according to Claim 11, **characterised in that**, if an insulation fault is detected on a conductor during the insulation test stage, it comprises a secondary insulation test stage consisting in measuring the resistance between the faulty conductor and all other conductors (4) of the substrate.

13. An electrical test device for conductors arranged on an insulating substrate, **characterised in that** it comprises:

   - at least one source of particles (17, 17') associated with control means (11) in order to emit a beam of particles in the direction of any determined point of a conductor (4) of insulating substrate (1) so as to extract electrons from said conductor and thus increase its electric potential,

   - at least one plate (2, 2') arranged opposite a respective face of the insulating substrate, and comprising conductive areas (8, 10) in any region adjacent to the vertical of a conductor (4, 4') of substrate (1) to be tested,

   - means for injecting electrons into any determined point (C) of a conductor (4, 4') on insulating substrate (1), and

   - a control and measuring unit (11) for individually charging conducting areas (8, 10) to any adjustable electric potentials, and for measuring currents and voltages between any two preselected, conductive areas (8, 10).

14. The device according to Claim 13, **characterised in that** the source of particles is an ultraviolet light source (17, 17').

15. The device according to Claim 13 or 14, **characterised in that** it comprises a plurality of laser microsources distributed over the surface of plate (2, 2').

16. The device according to Claim 14, **characterised in that** each ultraviolet light source (17, 17') is arranged at a distance from plate (2) and emits a beam, the inclination of which can be adjusted about an angle of 90° in relation to the plane of plate (2, 2').

17. The device according to any one of Claims 13 to 16, **characterised in that** it comprises a matrix network of sets (24) arranged on plate (2, 2') of micropoints individually controlled in order to emit electrons in the direction of any one of conductors (4) of substrate (1).

18. The device according to Claim 13, **characterised in that** it comprises a network (33) of conductive regions divided into pixels in contact with an anistropically conductive, elastomer sheet (35) in a direction perpendicular to said surface, this elastomer sheet being applied against conductor (4), each conductive region capable of being individually charged to any adjustable potential.

19. The device according to any one of Claims 13 to 18, **characterised in that** the means for injecting electrons comprise a plurality of electron sources divided according to a matrix network and individually controllable by line/column addressing.

20. The device according to any one of Claims 13 to 19, **characterised in that** control and measuring unit (11) comprises addressing means in order to select conductive areas (8, 10) of plates (2, 2') to be charged to a determined potential and from which the current or the voltage are measured.

21. The device according to any one of Claims 13 to 20, **characterised in that** it comprises a partial vacuum chamber (12) in which insulating substrate (1) and each plate (2, 2') are arranged.

Fig. 1

Fig. 2

Fig. 3

Fig. 4

Fig. 5

Fig. 6

Fig. 7

Fig. 8